# FASCICULE DE BREVET EUROPEEN

(11) **EP 3 443 361 B1**
(45) Date de publication et mention de la délivrance du brevet: **01.01.2020**
(21) Numéro de dépôt: 17720548.1
(22) Date de dépôt: 05.04.2017
(51) Int. Cl.: G01P 15/135, H01H 35/14, G01P 15/08

(54) **ACCÉLÉROMÈTRE BASSE CONSOMMATION**
BESCHLEUNIGUNGSMESSER MIT GERINGER LEISTUNGSAUFNAHME
LOW-POWER ACCELEROMETER

(30) Priorité: 12.04.2016 FR 1653228
(43) Date de publication de la demande: 20.02.2019
(73) Titulaire: Delorme, Nicolas, Pierre, 38000 Grenoble (FR); Saias, Daniel, 38000 GRENOBLE (FR)
(72) Inventeur: Delorme, Nicolas, Pierre, 38000 Grenoble (FR); Saias, Daniel, 38000 GRENOBLE (FR)
(74) Mandataire: de Jong, Jean Jacques
(86) Numéro de dépôt international: PCT/FR2017/050803
(87) Numéro de publication internationale: WO 2017/178732

(56) Documents cités:
- WO-A1-95/27217
- WO-A1-2016/087073
- Varun Kumar et al: "Ultra-low power self-computing binary output digital MEMS accelerometer", IEEE XPlore Digital Library, 29 février 2016 (2016-02-29), pages 251-254, XP002763476, 2016 IEEE 29th International Conference on MEMS, Shanghai 24-28 January 2016 DOI: 10.1109/MEMSYS.2016.7421607 ISBN: 978-1-5090-1973-1 Extrait de l'Internet: URL:http://ieeexplore.ieee.org/xpl/mostRec entIssue.jsp?punumber=7411154 [extrait le 2016-10-26] cité dans la demande

## Description

### Domaine technique

L'invention est relative aux accéléromètres, et plus spécifiquement aux accéléromètres réalisés selon une technologie MEMS.

### Arrière-plan

Les accéléromètres MEMS utilisent typiquement des masselottes mobiles dont le déplacement est mesuré par effet capacitif Pour mesurer une capacité, on utilise généralement des composants analogiques opérant à fréquence élevée, provoquant une consommation électrique significative. La consommation des composants analogiques d'un accéléromètre MEMS peut représenter plus de 80 % de la consommation totale.

L'article [Varun Kumar et al., "Ultra-Low Power Self-Computing Binary Output Digital MEMS Accelerometer", MEMS 2016, Shanghai, CHINA, 24-28 January 2016] propose un accéléromètre MEMS à sortie binaire, comprenant autant de masselottes que de bits à produire. Chaque masselotte est suspendue à une paroi fixe par un ressort et est associée à une butée contre laquelle la masselotte vient en appui lorsque l'accélération est suffisante. La butée et la masselotte sont revêtues de métallisations, de sorte que l'appui de la masselotte sur la butée ferme un contact électrique pour représenter un « 1 » binaire.

Les masselottes ont la même masse et les constantes de raideur des ressorts suivent une progression géométrique de raison 2. Avec cette configuration, une masselotte donnée vient en appui sur sa butée pour une accélération double de celle mettant la masselotte précédente en appui sur sa butée. Pour que le code fourni soit binaire, l'article propose d'associer des actuateurs électrostatiques aux masselottes, commandés pour décoller chaque masselotte de sa butée au moment où une masselotte de rang supérieur entre en contact avec sa butée.

Un tel accéléromètre binaire, bien qu'il n'utilise pas des composants analogiques pour exploiter le signal, demande une certaine puissance électrique pour commander les actuateurs. En outre, il est difficile de dimensionner les actuateurs et de produire en technologie MEMS des ressorts qui ont des raideurs suffisamment précises selon une progression géométrique.

### Résumé

On prévoit de façon générale un accéléromètre comprenant plusieurs masselottes mobiles selon un axe de mesure ; un ressort respectif solidaire de chaque masselotte, configuré pour exercer un rappel élastique sur la masselotte dans l'axe de mesure ; une butée fixe associée à chaque masselotte, agencée pour intercepter la masselotte lorsque l'accélération dans l'axe de mesure augmente d'un pas ; et un contact électrique associé à chaque butée, configuré pour être fermé lorsque la masselotte associée atteint la butée. Les masselottes sont suspendues les unes aux autres en série par les ressorts dans l'axe de mesure, les butées étant agencées pour intercepter successivement les masselottes respectives pour des seuils d'accélération croissants.

Chacune des première et dernière masselottes de la série peut être suspendue à un point fixe par un ressort.

Les butées peuvent être agencées pour intercepter en alternance une masselotte de rang décroissant depuis le dernier rang de la série et une masselotte de rang croissant depuis le premier rang de la série.

L'accéléromètre peut comprendre deux butées par masselotte, une première des deux butées étant agencée pour intercepter la masselotte dans un premier sens de déplacement selon l'axe de mesure, et la deuxième butée étant agencée pour intercepter la masselotte dans le sens de déplacement opposé.

L'accéléromètre peut comprendre une paire de butées par masselotte, les deux butées de la paire étant disposées à des extrémités opposées de la masselotte transversalement à l'axe de mesure.

Chaque masselotte et ses butées peuvent être configurées pour fermer le contact électrique lorsque la masselotte appuie simultanément sur les deux butées.

Les deux butées d'une paire associée à une masselotte peuvent, au contraire, être décalées l'une par rapport à l'autre dans l'axe de mesure.

Les masselottes peuvent avoir la même masse et les ressorts la même constante de raideur.

Les masselottes et les ressorts peuvent être réalisés d'une pièce en silicium, les masselottes ayant un facteur de forme allongé transversalement à l'axe de mesure, et les ressorts étant des ressorts à lames transversales à l'axe de mesure.

### Description sommaire des dessins

Des modes de réalisation seront exposés dans la description suivante, faite à titre non limitatif en relation avec les figures jointes parmi lesquelles :
- les figures 1A à 1D, sont des schémas de principe d'un premier mode de réalisation d'accéléromètre thermométrique, dans des configurations résultant de différentes valeurs d'accélération ;
- les figures 2A à 2D, sont des schémas de principe d'un deuxième mode de réalisation d'accéléromètre thermométrique, dans des configurations résultant de différentes valeurs d'accélération ;
- la figure 3 représente à l'échelle un mode de réalisation détaillé d'un accéléromètre thermométrique selon le principe des figures 2A à 2D, réalisé en technologie MEMS ;
- la figure 4 est un graphe illustrant la réponse de l'accéléromètre de la figure 3 pour deux séries d'écartements des butées ; et
- les figures 5A à 5D sont des schémas de principe d'une variante d'accéléromètre thermométrique, dans des configurations résultant de différentes valeurs d'accélération.

### Description de modes de réalisation

On cherche ici à réaliser un accéléromètre fournissant, comme celui de l'article susmentionné de Varun Kumar, des mesures d'accélération discrètes par les états d'interrupteurs mécaniques. On souhaite de plus que l'accéléromètre soit entièrement passif et présente peu de difficultés de dimensionnement pour fournir une mesure fiable.

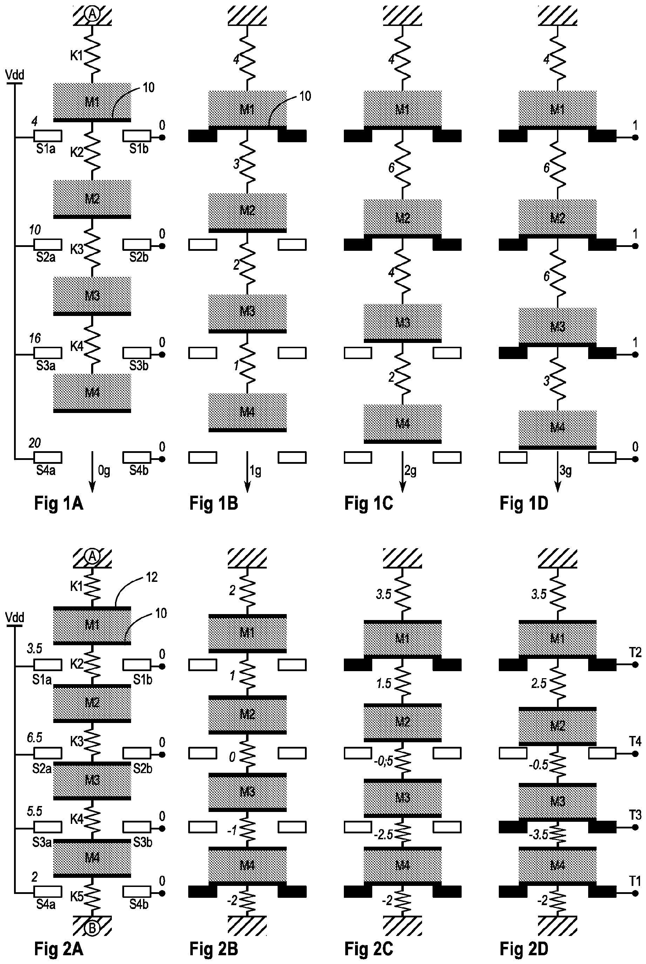

La figure 1A est un schéma de principe d'un premier mode de réalisation d'un tel accéléromètre, dans une position de repos, c'est-à-dire sous une accélération nulle notée 0g. Il comprend plusieurs masselottes, ici quatre, M1 à M4, suspendues les unes aux autres en série dans l'axe de l'accélération à mesurer, ici l'axe nord-sud. Chaque masselotte est suspendue à la précédente par un ressort respectif K1 à K4, la première masselotte M1 étant suspendue à un point fixe A par le ressort K1.

A chaque masselotte Mi est associée une butée conductrice Sia agencée pour intercepter la masselotte dans un sens de déplacement selon l'axe de mesure, ici vers le sud. Comme les masselottes ont un degré de liberté en roulis, on préfère prévoir une paire de butées Sia, Sib de part et d'autre de l'axe de mesure, permettant d'immobiliser la masselotte en roulis.

Les deux butées conductrices Sia et Sib associées à une masselotte Mi forment deux bornes d'un interrupteur mécanique. La masselotte Mi comporte une zone conductrice 10 en face des butées, qui relie électriquement les deux butées lorsque la masselotte est en appui sur celles-ci. Comme cela est représenté, les butées Sia peuvent être reliées à un potentiel commun Vdd correspondant, par exemple, au niveau logique « 1 ». Les butées Sib forment alors des bornes sur lesquelles on prélève le niveau d'accélération selon un code thermométrique. Le code thermométrique peut être linéaire ou autre selon les choix des écartements des butées par rapport aux positions de repos des masselottes.

Les masselottes peuvent avoir toutes la même masse m et les ressorts la même constante de raideur k. En supposant que mg/k = 1, un ressort K s'allonge de 1 pour une accélération de 1g (où g est la constante de gravité). On a indiqué un exemple d'écartements pour les butées S1a à S4a sur la figure 1A, à savoir 4, 10, 16 et 20, fournissant dans ces conditions un code thermométrique linéaire pour une accélération allant de 0 à 4g.

La figure 1B illustre la configuration de l'accéléromètre soumis à une accélération de 1g vers le sud. Les ressorts K1 à K4 s'allongent respectivement de 4, 3, 2 et 1. La masselotte M1 s'arrête sur les butées S1a et S1b, fermant l'interrupteur correspondant, ce qui est illustré par les butées noircies. L'accéléromètre indique une accélération de 1g par le code thermométrique 0001 prélevé sur les butées Sib à S4b.

La figure 1C illustre la configuration de l'accéléromètre soumis à une accélération de 2g vers le sud. La masselotte M1 étant bloquée, le ressort K1 ne s'allonge plus. Les ressorts K2 à K4 continuent à s'allonger et leurs allongements atteignent respectivement 6, 4 et 2. La masselotte M2 s'arrête sur les butées S2a et S2b, fermant l'interrupteur correspondant. L'accéléromètre indique une accélération de 2g par le code thermométrique 0011 prélevé sur les butées S1b à S4b.

La figure 1D illustre la configuration de l'accéléromètre soumis à une accélération de 3g vers le sud. Les masselottes M1 et M2 étant bloquées, les ressorts K1 et K2 ne s'allongent plus. Les ressorts K3 et K4 continuent à s'allonger et leurs allongements atteignent respectivement 6 et 3. La masselotte M3 s'arrête sur les butées S3a et S3b, fermant l'interrupteur correspondant. L'accéléromètre indique une accélération de 3g par le code thermométrique 0111 prélevé sur les butées S1b à S4b.

Lorsque l'accéléromètre est soumis à 4g, la dernière masselotte M4 s'arrête sur les butées S4a et S4b, le ressort K4 atteignant un allongement de 4. Le code thermométrique affiche alors 1111.

L'allongement total du système est de 20, correspondant à l'écartement entre la dernière paire de butées S4a, S4b et la position de repos de la dernière masselotte M4.

La figure 2A est un schéma de principe d'un deuxième mode de réalisation d'accéléromètre thermométrique adapté à la mesure d'accélérations pouvant être dans les deux sens de l'axe de mesure. Par rapport au mode de réalisation précédent, la dernière masselotte M4 est reliée à un point fixe B par un ressort additionnel K5 qui peut avoir la même constante de raideur que les autres ressorts. Les points A et B définissent l'axe de mesure de l'accélération, noté AB. La structure se comporte ainsi de manière symétrique par rapport aux deux sens de l'accélération, de A vers B et de B vers A.

En supposant de nouveau que mg/k = 1, on peut calculer que les allongements des ressorts pour une accélération de 1g valent respectivement 2, 1, 0, -1, -2 pour les ressorts K1 à K5. Un allongement négatif signifie que le ressort est comprimé. De façon générale, pour un système à N masselottes et N+1 ressorts, les allongements valent N/2, N/2 - 1, N/2 - 2,... N/2 - i,... -N/2 + i,... -N/2.

La figure 2B illustre la configuration de l'accéléromètre soumis à une accélération de 1g de A vers B. Comme indiqué ci-dessus, les ressorts K1 à K5 s'allongent respectivement de 2, 1, 0, -1, -2. Les écartements des butées ont été choisis ici pour que la dernière masselotte M4 soit interceptée en premier.

En fait, les butées sont configurées pour intercepter en alternance une masselotte de rang décroissant depuis le dernier rang de la série et une masselotte de rang croissant depuis le premier rang de la série. Cela permet de borner l'allongement des ressorts. Le choix de la masselotte de départ (la dernière ou la première) est indifférent. Pour produire le code thermométrique, les rangs des butées S1b à S4b sont réorganisés. Le code thermométrique est prélevé dans l'ordre sur des bornes T1 à T4 qui correspondent respectivement aux butées S4b, S1b, S3b et S2b.

Ainsi, la masselotte M4 s'arrête sur les butées S4a et S4b, fermant l'interrupteur correspondant, ce qui est illustré par les butées noircies. L'accéléromètre indique une accélération de 1g par le code thermométrique 0001 prélevé sur les bornes T1 à T4. Les butées S4a et S4b ont ainsi un écartement de 2 par rapport à la position de repos de la masselotte M4.

La figure 2C illustre la configuration de l'accéléromètre soumis à une accélération de 2g vers le sud. La masselotte M4 étant bloquée, le ressort K5 ne travaille plus. Le système ne comprend plus que 3 masselottes et 4 ressorts. Les ressorts K1 à K4 continuent à se déformer et leurs allongements atteignent respectivement 3,5, 1,5, -0,5 et -2,5. La masselotte M1 s'arrête sur les butées S1a et S1b, fermant l'interrupteur correspondant. L'accéléromètre indique une accélération de 2g par le code thermométrique 0011 prélevé sur les bornes T1 à T4. Les butées S1a et S1b ont ainsi un écartement de 3,5 par rapport à la position de repos de la masselotte M1.

La figure 2D illustre la configuration de l'accéléromètre soumis à une accélération de 3g vers le sud. Les masselottes M1 et M4 étant bloquées, les ressorts K1 et K5 ne se déforment plus. Le système ne comprend plus que 2 masselottes et 3 ressorts. Les ressorts K2 à K4 continuent à se déformer et leurs allongements atteignent respectivement 2,5, -0,5 et -3,5. La masselotte M3 s'arrête sur les butées S3a et S3b, fermant l'interrupteur correspondant. L'accéléromètre indique une accélération de 3g par le code thermométrique 0111 prélevé sur les bornes T1 à T4. Les butées S3a et S3b ont ainsi un écartement de 5,5 par rapport à la position de repos de la masselotte M3.

Lorsque l'accéléromètre est soumis à 4g, la masselotte M2 s'arrête sur les butées S2a et S2b, les ressorts K2 et K3 atteignant des allongements respectifs de 3 et -1. Le code thermométrique affiche alors 1111. Les butées S2a et S2b ont ainsi un écartement de 6,5 par rapport à la position de repos de la masselotte M2.

Pour mesurer une accélération de sens inverse (de B vers A), le système comprendra un deuxième jeu de butées (non représenté) symétrique au premier jeu de butées, coopérant avec les faces supérieures des masselottes. Les faces supérieures des masselottes peuvent ainsi comporter, comme cela est représenté, une zone conductrice 12.

Les masselottes soumises aux plus grands déplacements sont celles près du centre, le déplacement maximal dans cet exemple étant de 6,5 pour la masselotte M2.

Un tel accéléromètre thermométrique fournit un état représentatif de l'accélération sans consommer de courant. Le circuit d'exploitation, qui peut être entièrement numérique, est alors conçu pour appliquer un potentiel représentatif de l'état logique « 1 » (par exemple Vdd) aux butées conductrices Sia et prélever les états logiques présents sur les bornes T1 à T4.

Sur le terrain, l'accéléromètre peut être soumis à des impacts et des composantes d'accélération désaxées qui font rebondir transitoirement les masselottes sur les butées, provoquant des contacts électriques intermittents. Le fait de prévoir deux butées par masselotte offre un pré-filtrage des rebonds, en ce que l'état 1 du bit correspondant n'est confirmé que si la masselotte est en appui simultané sur les deux butées. Le fait même que le code soit thermométrique offre un filtrage supplémentaire, en ce que le code n'est confirmé que si tous les bits de rang inférieur sont à 1.

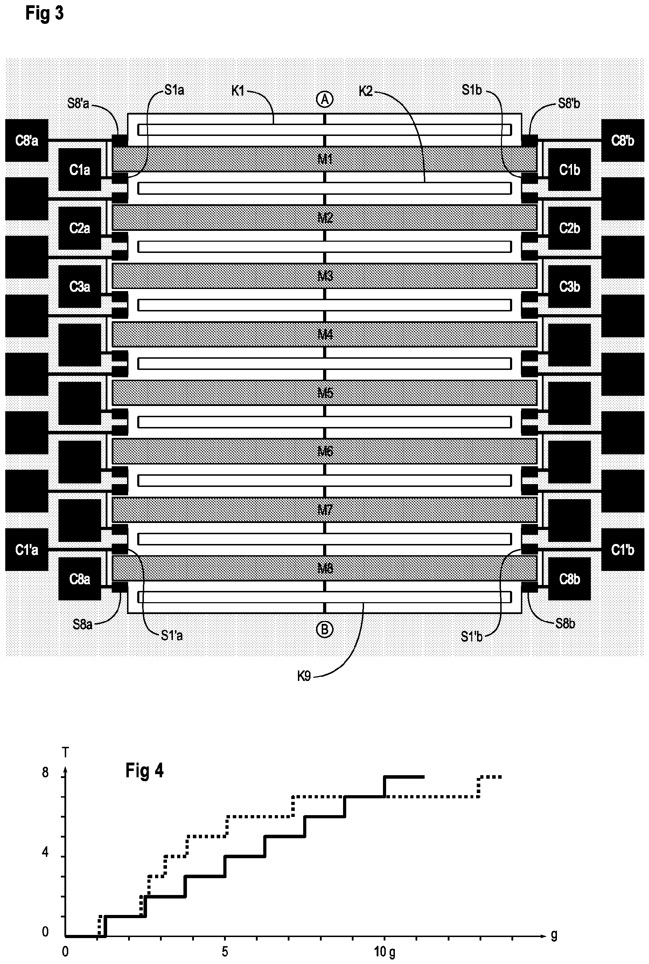

La figure 3 représente à l'échelle un exemple de réalisation détaillé d'un accéléromètre thermométrique selon le principe de la figure 2A, réalisé en technologie MEMS. Les masselottes et les ressorts sont gravés dans un substrat en silicium selon une technologie permettant de creuser des tranchées et de retirer la matière sous la structure gravée. La structure gravée comprend ici huit masselottes M1 à M8 et neuf ressorts K1 à K9, les ressorts K1 et K9 reliant la structure au substrat fixe en A et B. Dans ce mode de réalisation, les masselottes ont un facteur de forme allongé transversalement à l'axe de mesure AB. Les ressorts sont des ressorts à lames transversales à l'axe de mesure. Les paires de butées conductrices sont structurées dans les parois du caisson logeant les masselottes et les ressorts. On a représenté ici deux jeux de paires de butées, à savoir un jeu Sia, Sib (où i varie de 1 à 8) coopérant avec les faces inférieures des masselottes et servant à la mesure d'une accélération de A vers B, et un jeu Si'a, Si'b coopérant avec les faces supérieures des masselottes et servant à la mesure d'une accélération de B vers A. Chaque butée conductrice est individuellement accessible par un plot de contact Cia, Cib, Ci'a, ou Ci'b.

A titre d'exemple, la structure a une épaisseur de 50 micromètres. Chaque masselotte a une largeur de 800 micromètres et une longueur de 10 micromètres (dans le sens de l'axe de mesure). Les lames des ressorts ont une longueur de 350 micromètres et une largeur de 1 micromètre. Chaque ressort comprend quatre lames dans une configuration parallèle-série symétrique par rapport à l'axe AB. La figure 3 est représentée à l'échelle de ces dimensions.

En exploitant le système comme illustré aux figures 2A à 2D, c'est-à-dire en agençant les butées pour intercepter alternativement les masselottes du haut et du bas, et en supposant mg/k = 1, on obtient la série d'écartements normalisés suivante pour les huit paires de butées, dans le sens des rangs 1 à 8 :

| | | | | | | | |
|---|---|---|---|---|---|---|---|
| 7,5 | 18,5 | 29 | 35 | 33 | 24,5 | 13,5 | 4 |

Ces écartements sont définis pour incrémenter le code thermométrique d'un pas pour chaque pas d'accélération de 1g, en d'autres termes pour obtenir un code thermométrique linéaire. Dans la structure en silicium de la figure 3, avec les dimensions indiquées, on peut considérer la série d'écartements suivante en micromètres. Ces écartements sont illustrés sensiblement à l'échelle sur la figure 3.

| | | | | | | | |
|---|---|---|---|---|---|---|---|
| 1,1 | 2,65 | 4,2 | 5,07 | 4,78 | 3,55 | 1,95 | 0,58 |

Avec ces valeurs, proportionnelles aux valeurs normalisées ci-dessus, on obtient un code thermométrique linéaire sur une échelle de 0 à 10g. Chaque pas du code thermométrique correspond alors à un pas d'accélération de 1,25g. On rappelle que le code thermométrique est formé dans l'ordre d'interception des masselottes lorsque l'accélération croît, ici 8-1-7-2-6-3-5-4, qui est différent de l'ordre des positions des masselottes (1 à 8).

La figure 4 est un graphe illustrant la réponse de l'accéléromètre de la figure 3 pour deux séries d'écartements des butées. La courbe de réponse en trait plein correspond aux écartements ci-dessus, fournissant une réponse linéaire.

Les écartements peuvent toutefois être définis avec une certaine liberté par le concepteur selon le type de réponse qu'il souhaite ou la résolution de la technologie. La courbe en pointillés correspond à la série d'écartements linéaire suivante (en micromètres) :

| | | | | | | | |
|---|---|---|---|---|---|---|---|
| 1 | 2 | 3 | 4 | 3,5 | 2,5 | 1,5 | 0,5 |

Ces valeurs fournissent une réponse non-linéaire, toutefois monotone, sensiblement en « S ».

Dans les figures précédentes, les deux butées de chaque paire étaient agencées à la même distance de la masselotte correspondante et ce n'est que si la masselotte était en appui sur les deux butées simultanément que le contact électrique était fermé.

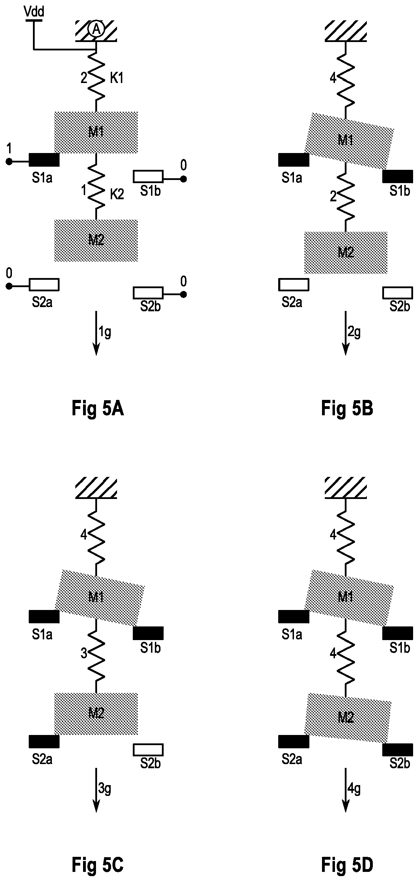

Dans les figures 5A à 5D, la deuxième butée de chaque paire est décalée par rapport à la première. L'accéléromètre représenté, du type de la figure 1B à titre d'exemple, ne comporte que deux masselottes.

Dans la figure 5A, l'accéléromètre est soumis à une accélération de 1g vers le sud. Les ressorts K1 et K2 s'allongent respectivement de 2 et 1. La masselotte M1 atteint seulement la butée S1a. Ce contact établit un premier pas du code thermométrique. Pour détecter ainsi un contact avec une seule butée, l'ensemble des ressorts et des masselottes peut être conducteur et mis au potentiel Vdd, comme cela est représenté. Dans le cadre d'une technologie MEMS, la structure des masselottes, en silicium, peut être rendue conductrice par dopage.

Dans la figure 5B, l'accéléromètre est soumis à une accélération de 2g. La masselotte M1 continue à descendre, en tournant autour de son point d'appui sur la butée S1a, de sorte que son extrémité libre se déplace deux fois plus vite que son centre. Les ressorts K1 et K2 atteignent des allongements respectifs de 4 et 2. La butée S1b est agencée pour être atteinte dans cette configuration par l'extrémité mobile de la masselotte M1 et établir le deuxième pas du code thermométrique. La butée S1b est ainsi décalée de 4 vers le bas par rapport à la butée S1a.

Dans la figure 5C, l'accéléromètre est soumis à une accélération de 3g. La masselotte M1 est bloquée, de sorte que le ressort K1 ne s'allonge plus. Le ressort K2 atteint un allongement de 3. La butée S2a est agencée pour être atteinte dans cette configuration par la masselotte M2 et établir le troisième pas du code thermométrique.

Dans la figure 5D, l'accéléromètre est soumis à une accélération de 4g. La masselotte M2 continue à descendre, en tournant autour de son point d'appui sur la butée S2a. Le ressort K2 atteint un allongement de 4. La butée S2b est agencée pour être atteinte dans cette configuration par l'extrémité mobile de la masselotte M2 et établir le quatrième pas du code thermométrique. La butée S2b est ainsi décalée de 2 vers le bas par rapport à la butée S2a.

Avec cette configuration d'accéléromètre, on double la résolution du code thermométrique pour un nombre donné de masselottes et de ressorts. La rotation des masselottes a été exagérée dans les figures 5B à 5D, qui sont schématiques. Si on applique cet agencement décalé des butées dans une structure réelle, comme celle de la figure 3, on constate que la rotation des masselottes reste à peine perceptible compte tenu du facteur de forme allongé des masselottes et des petits espacements des butées.

Le fait que les masselottes et les ressorts sont physiquement identiques dans les exemples décrits simplifie la conception de l'accéléromètre et garantit la reproductibilité de la réponse de l'accéléromètre dans une fabrication en série. En effet, il est plus facile, dans un même dispositif, de réaliser des éléments ayant les mêmes caractéristiques (masse, constante de raideur) que des éléments devant respecter un rapport de caractéristiques (rapports 2 et 4 entre les constantes de raideur dans l'article susmentionné de Varun Kumar). Bien entendu, les masselottes et les ressorts peuvent avoir des caractéristiques différentes si cela satisfait un besoin du concepteur.

## Revendications

1. Accéléromètre comprenant :
• plusieurs masselottes mobiles (M1-M4) selon un axe de mesure (AB) ;
• un ressort respectif (K1-K4) solidaire de chaque masselotte, configuré pour exercer un rappel élastique sur la masselotte dans l'axe de mesure ;
• une butée fixe (S1-S4) associée à chaque masselotte, agencée pour intercepter la masselotte lorsque l'accélération dans l'axe de mesure augmente d'un pas ; et
• un contact électrique associé à chaque butée, configuré pour être fermé lorsque la masselotte associée atteint la butée ;
**caractérisé en ce que** les masselottes sont suspendues les unes aux autres en série par les ressorts dans l'axe de mesure, les butées étant agencées pour intercepter successivement les masselottes respectives pour des seuils d'accélération croissants.

2. Accéléromètre selon la revendication 1, dans lequel chacune des première et dernière masselottes (M1, M4) de la série est suspendue à un point fixe (A, B) par un ressort (K1, K5).

3. Accéléromètre selon la revendication 2, dans lequel les butées sont agencées pour intercepter en alternance une masselotte de rang décroissant depuis le dernier rang de la série et une masselotte de rang croissant depuis le premier rang de la série.

4. Accéléromètre selon la revendication 2, comprenant deux butées (S1a, S8'a) par masselotte, une première des deux butées étant agencée pour intercepter la masselotte dans un premier sens de déplacement selon l'axe de mesure, et la deuxième butée étant agencée pour intercepter la masselotte dans le sens de déplacement opposé.

5. Accéléromètre selon la revendication 1, comprenant une paire de butées (S1a, S1b) par masselotte, les deux butées de la paire étant disposées à des extrémités opposées de la masselotte transversalement à l'axe de mesure.

6. Accéléromètre selon la revendication 5, dans lequel chaque masselotte et ses butées sont configurées pour fermer le contact électrique lorsque la masselotte appuie simultanément sur les deux butées.

7. Accéléromètre selon la revendication 5, dans lequel les deux butées d'une paire associée à une masselotte sont décalées l'une par rapport à l'autre dans l'axe de mesure.

8. Accéléromètre selon la revendication 1, dans lequel les masselottes ont la même masse (m) et les ressorts ont la même constante de raideur (k).

9. Accéléromètre selon la revendication 2, dans lequel les masselottes et les ressorts sont réalisés d'une pièce en silicium, les masselottes ayant un facteur de forme allongé transversalement à l'axe de mesure, et les ressorts étant des ressorts à lames transversales à l'axe de mesure.

## Patentansprüche

1. Beschleunigungsmesser, umfassend:
• mehrere bewegliche Gewichte (M1-M4) gemäß einer Messachse (AB);
• eine mit jedem Gewicht fest verbundene jeweilige Feder (K1-K4), die eingerichtet ist, um eine elastische Rückstellung auf das Gewicht in der Messachse auszuüben;
• einen jedem Gewicht zugeordneten festen Anschlag (S1-S4), der ausgebildet ist, um das Gewicht abzufangen, wenn die Beschleunigung in der Messachse um eine Stufe zunimmt; und
• einen jedem Anschlag zugeordneten elektrischen Kontakt, der eingerichtet ist, um geschlossen zu werden, wenn das zugeordnete Gewicht den Anschlag erreicht;
**dadurch gekennzeichnet, dass** die Gewichte durch die Federn in der Messachse in Reihe zueinander aufgehängt sind, wobei die Anschläge ausgebildet sind, um die jeweiligen Gewichte für zunehmende Beschleunigungsgrenzwerte nacheinander abzufangen.

2. Beschleunigungsmesser nach Anspruch 1, wobei jedes von dem ersten und letzten Gewicht (M1, M4) der Reihe durch eine Feder (K1, K5) an einem festen Punkt aufgehängt ist (A, B).

3. Beschleunigungsmesser nach Anspruch 2, wobei die Anschläge ausgebildet sind, um abwechselnd ein Gewicht niedrigeren Rangs ab dem letzten Rang der Reihe und ein Gewicht höheren Rangs ab dem letzten Rang der Reihe abzufangen.

4. Beschleunigungsmesser nach Anspruch 2, umfassend zwei Anschläge (S1a, S8'a) je Gewicht, wobei ein erster der zwei Anschläge ausgebildet ist, um das Gewicht in einer ersten Verlagerungsrichtung gemäß der Messachse abzufangen, und der zweite Anschlag ausgebildet ist, um das Gewicht in der entgegengesetzten Verlagerungsrichtung abzufangen.

5. Beschleunigungsmesser nach Anspruch 1, umfassend ein Paar von Anschlägen (S1 a, S1b) je Gewicht, wobei die zwei Anschläge des Paares an gegenüberliegenden Enden des Gewichts quer zur Messachse angeordnet sind.

6. Beschleunigungsmesser nach Anspruch 5, wobei jedes Gewicht und seine Anschläge eingerichtet sind, um den elektrischen Kontakt zu schließen, wenn das Gewicht gleichzeitig auf zwei Anschläge drückt.

7. Beschleunigungssensor nach Anspruch 5, wobei die zwei Anschläge eines einem Gewicht zugeordneten Paares in der Messachse zueinander versetzt sind.

8. Beschleunigungsmesser nach Anspruch 1, wobei die Gewichte dieselbe Masse (m) haben und die Federn dieselbe Federkonstante (k) haben.

9. Beschleunigungsmesser nach Anspruch 2, wobei die Gewichte und die Federn aus einem Teil aus Silizium hergestellt sind, wobei die Gewichte einen transversal zur Messachse länglichen Formfaktor haben und die Federn Federn mit transversalen Lamellen zur Messachse sind.

## Claims

1. An accelerometer comprising:
• a plurality of proof-masses (M1-M4) movable along a measurement axis (AB);
• a respective spring (K1-K4) attached to each proof-mass, configured to exert an elastic return on the proof-mass along the measurement axis;
• a fixed stop (S1-S4) associated with each proof-mass, arranged to intercept the proof-mass when the acceleration along the measurement axis increases by one step; and
• an electrical contact associated with each stop, configured to be closed when the associated proof-mass reaches the stop;
**characterized in that** the proof-masses are suspended with respect to one and other by the springs, in series along the measurement axis, the stops being arranged to successively intercept the respective proof-masses for increasing acceleration thresholds.

2. The accelerometer according to claim 1, wherein each of the first and last proof-masses (M1, M4) of the series is suspended to a fixed point (A, B) by a spring (K1, K5).

3. The accelerometer according to claim 2, wherein the stops are arranged to intercept alternately a proof-mass of rank decreasing from the last rank of the series and a proof-mass of rank increasing from the first rank of the series.

4. The accelerometer according to claim 2, comprising two stops (S1a, S8'a) per proof-mass, a first of the two stops being arranged to intercept the proof-mass in a first direction of travel along the measurement axis, and the second stop being arranged to intercept the proof-mass in the opposite direction of travel.

5. The accelerometer according to claim 1, comprising a pair of stops (S1a, S1b) for each proof-mass, the two stops of the pair being arranged at opposite ends of the proof-mass transversely to the measurement axis.

6. The accelerometer according to claim 5, wherein each proof-mass and its two stops are configured to close the respective electrical contact when the proof-mass rests simultaneously on the two stops.

7. The accelerometer according to claim 5, wherein the two stops of a pair associated with a proof-mass are offset relative to each other along the measurement axis.

8. The accelerometer according to claim 1, wherein the proof-masses have the same weight (m) and the springs have the same stiffness constant (k).

9. The accelerometer according to claim 2, wherein the proof-masses and springs are integrally made of silicon, the proof-masses having a shape factor elongated transversely to the measurement axis, and the springs being leaf springs transverse to the measuring axis.
